# EUROPÄISCHE PATENTSCHRIFT

(11) **EP 3 337 301 B1**
(45) Veröffentlichungstag und Bekanntmachung des Hinweises auf die Patenterteilung: **01.05.2024**
(21) Anmeldenummer: 17207467.6
(22) Anmeldetag: 14.12.2017
(51) Int. Cl.: H05K 1/02, H05K 3/20, F21K 9/00, F21V 23/00, H05K 1/05, H05K 3/10, H05K 3/30, H05K 3/38

(54) **VERFAHREN ZUR HERSTELLUNG EINES LED-MODULS**
METHOD FOR MANUFACTURING A LED MODULE
PROCÉDÉ DE FABRICATION D'UN MODULE LED

(30) Priorität: 15.12.2016 DE 102016124559
(43) Veröffentlichungstag der Anmeldung: 20.06.2018
(73) Patentinhaber: SITECO GmbH, 83301 Traunreut (DE)
(72) Erfinder: Wimmer, Kilian, 83362 Surberg (DE); Wuppinger, Bernhard, 83362 Surberg (DE)
(74) Vertreter: Schmidt, Steffen

(56) Entgegenhaltungen:
- DE-A1-102011 004 526
- US-A1- 2008 123 334
- US-A1- 2015 062 838

## Beschreibung

Die vorliegende Erfindung betrifft ein Verfahren zur Herstellung eines LED-Moduls. Die Erfindung betrifft weiterhin ein LED-Modul.

Leiterplatten (Printed Circuit Boards, PCB) werden im Allgemeinen benötigt um elektronische Bauteile, insbesondere LEDs, zu einer elektrischen Schaltung zusammenzufügen. Unterschiedliche elektronische Schaltungen benötigen unterschiedliche Leiterbahnführungen, das sogenannte Layout. Um eine elektronische Schaltung zu verbessern oder zu aktualisieren, benötigt man oftmals ein neues Layout und damit eine neue Leiterplatte. LED-Module werden in der Regel thermisch und mechanisch in den Leuchtengehäusen oder auf den jeweiligen Leuchtenträgern angebunden.

Die gängigste Art eine Leiterplatte für ein LED-Modul herzustellen ist das photochemische Verfahren umfassend die folgenden Herstellungsschritte:
1. Bohren
2. Durchkontaktieren (bei doppelseitigen Leiterplatten)
3. Fotoresist laminieren
4. Belichten
5. Entwickeln
6. Ätzen
7. Spülen
8. Trocknen

Wird ein Lötstopplack benötigt, so folgt der Auftrag als optionaler 9. Schritt. Dabei werden alle Kupferleiterbahnen mit Lack überzogen und die Kupferflächen, die später mit der LED verlötet werden, werden teillackiert.

US 2008/123334 A1 offenbart eine LED-Lichtvorrichtung mit einer Folie. Gemäß einer Ausführungsform dieser Druckschrift wird eine definierte Schaltung aus einer Metallfolie geschnitten und mittels einer Transferfolie auf eine Beschichtung eines Substrats übertragen.

DE 10 2011 004 526 A1 offenbart eine Leiterplatte mit hoher Stromtragfähigkeit und ein Verfahren zu deren Herstellung. Die Leiterplatten finden Verwendung in elektrischen Schaltungen, Starkstromelektroniken und nicht-automobilen Hochstromanwendungen. In dem Herstellungsverfahren ist vorgesehen, dass die Leiterplatte automatisch in einem SMD-Verfahren mit Leiterblechstücken bestückt wird.

US 2015/062838 A1 offenbart ein System zum Anbringen von Vorrichtungen auf flexiblen Substraten. Die Vorrichtung kann eine LED mit Leiterflächen umfassen. Diese werden mittels eines leitfähigen Klebstoffs auf Leiterbahnen einer flexiblen Platine befestigt. Die Befestigung kann durch einen automatisierten Bestückungsprozess erfolgen.

Aufgabe der vorliegenden Erfindung ist es, ein Verfahren zur Herstellung von LED-Modulen bereitzustellen, welches die Herstellung vereinfacht und/oder bessere thermische oder mechanische Eigenschaften des LED-Moduls ermöglicht.

Die Aufgabe wird gelöst durch ein Verfahren nach Anspruch 1.

Demnach umfasst ein Verfahren zur Herstellung eines LED-Moduls:
- Befestigen von Leiterflächen mit einer selbstklebenden Schicht auf einem Trägerelement, und
- Befestigen einer LED auf den Leiterflächen,
wobei das Befestigen der Leiterflächen durch einen SMD-Bestückungsautomaten erfolgt.

Dieses Verfahren hat den Vorteil, dass die Leiterflächen nicht als (nicht weggeätzter) Rest einer vollflächigen Beschichtung entstehen, sondern dass gezielt nur die Leiterflächen aufgetragen werden. Dies ist insbesondere dann vorteilhaft, wenn die Leiterflächen mit einer gewissen Dicke, z.B. größer als 0,05 mm, insbesondere größer als 0,1 mm, ausgeführt werden sollen, um eine ausreichende thermische Leitfähigkeit zu erzielen und somit eine bessere Wärmeabführung zu ermöglichen.

Erfindungsgemäß ist vorgesehen, dass das Befestigen der Leiterflächen umfasst, die selbstklebende Schicht auf die Leiterflächen aufzubringen und anschließend die Leiterfläche mit der selbstklebenden Schicht an dem Trägerelement zu befestigen. Dies hat den Vorteil, dass nur so viel Klebstoff verwendet werden muss, wie Leiterflächen befestigt werden müssen.

Vorzugsweise wird ein doppelseitiges, isolierendes Klebeband auf ein als Trägerelement dienendes Stahl- oder Aluminiumblech aufgeklebt und dann unbehandelte Kupferpads als Leiterflächen auf das Klebeband aufgesetzt.

Die selbstklebende Schicht kann ein elektrisch isolierendes Material aufweisen.

Gemäß einer bevorzugten Ausführungsform weisen die Leiterflächen eine Dicke zwischen 0,07 mm und 0,7 mm auf. Experimente haben gezeigt, dass damit eine gute Wärmeleitfähigkeit und gleichzeitig noch gute Handhabbarkeit der Leiterflächen in dem SMD-Bestückungsautomat erzielt werden kann.

Gemäß einer Ausführungsform sind Länge und Breite der Leiterflächen größer als Länge und Breite der LED. Dies hat den Vorteil, dass die Leiterfläche als Kühlkörper für die LED dienen kann.

Gemäß einer bevorzugten Ausführungsform umfasst die selbstklebende Schicht Polysiloxankleber, Acrylatkleber und/oder ein Polyimid-Klebeband mit einer Stärke von 5 µm bis 100 pm, vorzugsweise mit einer Stärke von 10 µm bis 50 µm.

Experimente haben gezeigt, dass die Leiterflächen damit besonders gut an dem Trägerelement befestigt werden können.

Gemäß einer bevorzugten Ausführungsform umfasst das Verfahren weiterhin:
- Erfassen von Abmessungen der Leiterflächen und
- basierend auf den Abmessungen, Berechnen einer Platzierung der Leiterflächen, um ein vorgegebenes Layout zu realisieren.

Die Abmessungen der Leiterflächen können z.B. in einer Datenbank gespeichert werden. Das Layout kann z.B. durch einen Benutzer eingegeben werden. Das Verfahren kann umfassen, zu bestimmen, mit welchen Kombinationen von Leiterflächen das so vorgegebene Layout realisiert werden kann. Sofern verschiedene Kombinationen von Leiterflächen in Frage kommen, kann die Kombination ausgewählt werden, mit der das Layout mit möglichst wenigen Leiterflächen realisiert werden kann.

Somit können auch komplizierte Layouts automatisch aus einer beschränkten Zahl von Leiterflächen unterschiedlicher Geometrien realisiert werden.

Gemäß einer bevorzugten Ausführungsform umfasst das Verfahren weiterhin, dass der SMD-Bestückungsautomat die Leiterflächen mit der selbstklebenden Schicht versieht. Somit können dem SMD-Bestückungsautomaten Leiterflächen ohne selbstklebende Schicht als Ausgangsmaterial bereitgestellt werden und automatisiert im SMD-Bestückungsautomat mit der selbstklebenden Schicht versehen werden.

Gemäß einer bevorzugten Ausführungsform werden die Leiterflächen über eine Schüttgutzuführung, eine Linearzuführung und/oder über eine Rolle als gegurtetes Vormaterial zugeführt.

Gemäß einer bevorzugten Ausführungsform ist vorgesehen, dass das Trägerelement auf der den Leiterflächen zugewandten Seite elektrisch leitend ist und die Leiterflächen eine Isolationsschicht aufweisen, wobei die Isolationsschicht vorzugsweise an die selbstklebende Schicht angrenzt.

Gemäß einer bevorzugten Ausführungsform ist vorgesehen, dass das Trägerelement eine Platte aus Verbund-Kunststoff, Glas und/oder Blech umfasst.

Das Blech kann lackiert oder unlackiert sein und z.B. Aluminium, Stahl und/oder verzinkten Stahl umfassen.

Gemäß einer bevorzugten Ausführungsform ist vorgesehen, dass die Leiterflächen Metall, insbesondere Kupfer, umfassen.

Ebenso kann die Leiterfläche auch Weißblech aufweisen.

Das LED-Modul kann Teil einer Leuchte sein oder die ganze Leuchte umfassen.

Da lineare wie flächige LED Module häufig aus mehreren LED Ketten bestehen, sind Layouts oft sehr einfach zu gestalten, ohne dass viele unterschiedliche Leiterbahnstrukturen nötig sind. Da das Trägerelement relativ frei gestaltet werden kann, kann das Trägerelement gleichzeitig das Gehäuse der Leuchte darstellen und eine lichttechnische Abdeckung aufnehmen.

Weitere Merkmale und Vorteile der vorliegenden Erfindung werden aus der nachfolgenden Beschreibung einer bevorzugten Ausführungsform deutlich, die in Verbindung mit den Figuren gegeben wird. In den Figuren ist Folgendes dargestellt:
Figur 1 zeigt eine Draufsicht auf eine Leiterfläche,
Figur 2 zeigte eine Seitenansicht einer Leiterfläche,
Figur 3 zeigt eine Draufsicht auf ein LED-Modul und
Figur 4 zeigt eine Seitenansicht eines LED-Moduls.

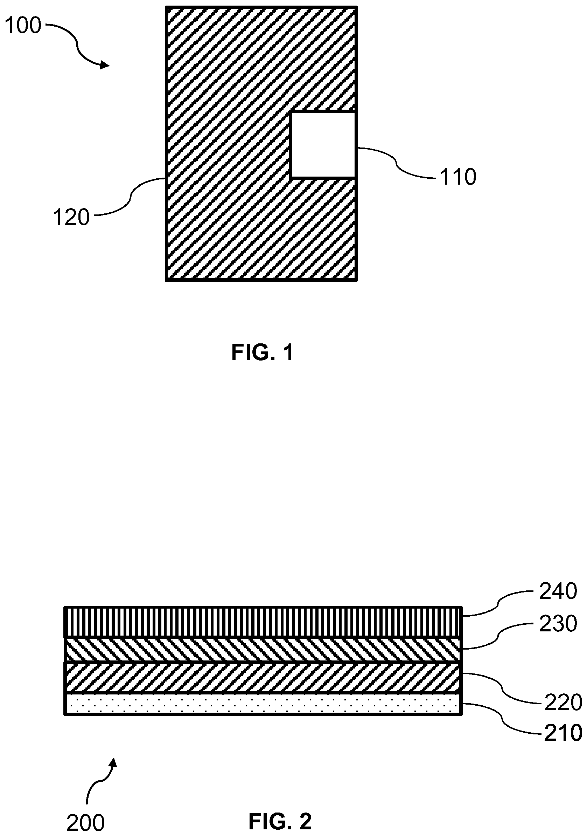

Figur 1 zeigt eine Draufsicht auf eine Leiterfläche 100. Dabei ist ein erster Bereich 110 einer blanken Kupferfläche sowie ein mit Lötstopplack versehener zweiter Bereich 120 sichtbar.

Figur 2 zeigt eine Seitenansicht eine Leiterfläche 200. Die Leiterfläche 200 umfasst dabei eine erste Schicht 210 aus einem selbstklebenden Material, eine zweite Schicht aus einem Dielektrikum 220, eine dritte Schicht 230 aus Kupfer sowie eine vierte Schicht 240 aus Lötstoppklack.

Durch den Lötstopplack kann
- der optische Reflektionsgrad erhöht,
- die Materialbeständigkeit und der Korrosionsschutz verbessert und
- die Ausrichtung der SMD-Bauteile im SMT- und Lötprozess verbessert werden.

Das Auftragen des Lötstopplacks kann über folgende Verfahren realisiert werden:
- Lackierverfahren (beispielsweise Siebdruck)
- Klebeband mit Aussparungen für die bestückten Bauteile (Beispiel: LEDs, Widerstände, Klemmen, ... )
- Die oben beschriebenen kupferkaschierten Labels können über der vollflächigen Kupferschicht teilweise mit Lötstopplack/Lötstopplackalternative (1d) überdeckt ausgeführt sein

Die Leiterflächen 100, 200 können Teile einer Leiterplatte eines LED-Moduls. Dieses LED-Modul kann erstellt werden, indem ein SMD Bestückungsautomat genutzt wird um die Leiterflächen, die das Layout der Leiterplatte bilden, in Form von einzelnen Pads unterschiedlicher Geometrie auf ein Trägerelement aufzusetzen.

Dabei kann der Bestückungsautomat Leiterflächen in Form von Etiketten 100, 200, d.h. Leiterflächen mit einer selbstklebenden Schicht, über eine Etiketten-Zuführung zugeführt werden.

Alternativ kann ein SMD-Bestückungsautomat Metallplättchen unterschiedlicher Stärke über eine Schüttgut-Zuführung zuführen, wobei die Metallplättchen vorzugsweise noch keine selbstklebende Schicht aufweisen. Eine Zuführung der Metallplättchen (z.B. Kupferpads) über eine Rolle als gegurtetes Vormaterial ist ebenfalls möglich.

Vorzugsweise weisen die Leiterflächen eine elektrisch und thermisch gut leitende Oberseite auf. Zum Beispiel können die Etiketten Kupfer und eine selbstklebende Unterseite mit z.B. Polysiloxankleber aufweisen. Die Leiterflächen mit selbstklebender Unterseite können als Rolle auf Trägerpapier verwendet werden.

Isolierte Leiterflächen können auch auf elektrisch leitende Träger geklebt werden, da die Leiterflächen die nötige Funktionsisolierung schon integriert haben. Die Leiterflächen können aber auch ohne Isolation ausgeführt werden, z.B. nur aus Leitschicht und Klebstoff bestehen. Diese können dann auf einen Funktionsisolator direkt bestückt werden. Untergründe hierfür könnten Holz, Kunststoff, Glas oder auch lackiertes Metallblech sein. Die verwendeten Materialien für die Leiterflächen (und auch den Träger) können sowohl reflowfähig (Temperaturbeständig bis ...) ausgeführt sein, als auch für niedrigschmelzende Lote oder elektrisch leitfähige Klebstoffe (Holzuntergrund) .

Werden als Leiterflächen Blechpads ohne eigene selbstklebende Schicht verwendet können diese ab einer gewissen Stärke (mechanischen Festigkeit) als Schüttgut zugeführt werden. Abhängig von der thermisch notwendigen Performance, können diese mit Stärken zwischen 0,05 mm und 0,5 mm ausgeführt werden. Diese Plättchen sind dann vorzugsweise entweder ohne weitere Schichten ausgeführt oder verfügen bereits über eine geeignete Passivierung (beispielsweise HAL, Chemisch-Zinn, OSP, ENIG, ... ). Die Plättchen werden vorzugsweise vom SMD-Bestückungsautomat direkt auf einen selbstklebenden Untergrund gesetzt oder der Bestückkopf greift das Kupferplättchen und lässt es von einem Dispenser innerhalb des Bestückungsautomaten an der Unterseite mit einem Klebstoff versehen. Ein geeigneter selbstklebender Untergrund kann z.B. ein Polyimid Klebeband mit einer Stärke zwischen 10 und 50 pm, insbesondere 25pm (Beispielsweise ein CMC 70752) sein. Ist dieses Klebeband doppelseitig klebend, kann es zuvor auf ein Trägerelement von unterschiedlichem Material gesetzt werden. Auf die nach oben hin freigelegte Klebeschicht können dann die Blechpads aufgesetzt werden.

Das Polyimid kann dabei zugleich die Aufgabe der Funktionsisolation und der normativ geforderten Isolation von typischerweise 2000V AC RMS übernehmen. Ist die Bestückung der Layoutpads auf einem elektrisch isolierenden Träger geplant, wie z.B. ein lackiertes Blech, dann können die Leiterflächen auch ohne einen Isolationsfilm aufgeklebt werden. Hierzu kann der Klebstoff beispielsweise unter Verwendung eines Schablonendruckers mit geeigneter Schablone auf den Träger gerakelt werden. Dadurch werden Klebstoffdepots genau an den Stellen und mit der Geometrie erzeugt, wo in einem zweiten Schritt die Metallpads mit dem SMD-Bestückungsautomaten aufgesetzt werden. Nachdem zur Fertigstellung der Elektronischen Flachbaugruppe zumeist ein Reflow Lötprozess nötig ist, eignen sich insbesondere Klebstoffe, die thermisch ausgehärtet werden.

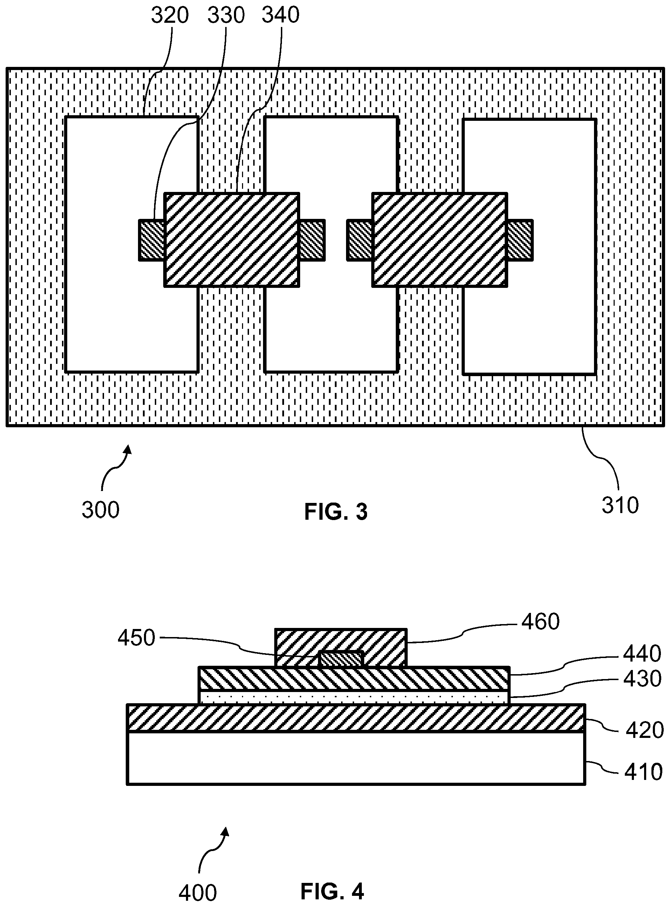

Figur 3 zeigt eine Draufsicht auf ein LED-Modul 300. Das LED-Modul umfasst ein Trägerelement 310, auf dem drei Leiterflächen 320 angeordnet sind. Zwischen den Leiterflächen 320 befinden sich LEDs 340, deren Anschlüsse 330 an den Leiterflächen 320 aufgelötet sind.

Figur 4 zeigt eine Seitenansicht auf ein LED-Modul 400. Das LED-Modul 400 umfasst ein Trägerelement 410, das gleichzeitig als Gehäuse des LED-Moduls dient. Auf dem Trägerelement aufgetragen ist ein vollflächiges Dielektrikum 420. Auf diesem ist eine Leiterfläche 440 mit einer selbstklebenden Schicht 430 befestigt. Auf der Leiterfläche 440 ist eine LED 460 mit einem Anschluss 450 befestigt, wobei der Anschluss 450 an der Leiterfläche 440 angelötet ist.

Die Leiterflächen können so ausgeformt werden, dass sie über ein Loch im Trägermaterial als Klemme für einen Draht dienen können (Rückseitige Verdrahtung). Oder die Leiterflächen werden so ausgeformt, dass sie eine bestückungsseitige Klemme ersetzen.

Somit lassen sich auf einfache Art und Weise alternativ auch längere Leiterbahnen (die mit dieser Technologie sonst nicht möglich sind) erzeugen, die der Verdrahtungsroboter einbringt. Dadurch können auch Parallelschaltungen von LED Ketten realisiert werden.

Die Erkenntnis, dass sich Layouts von LED Applikationen auf wenige geometrische Formen der Leiterflächen reduzieren lassen, macht es möglich ein Layout mit einem SMD-Bestückungsautomaten zu erstellen.

Im hier beschriebenen Fall handelt es sich um eine Vereinfachung des Layouts auf das absolute Minimum, um dann unter Verwendung von handelsüblichen Maschinen Layouts auftragsbezogen fertigen zu können. Das Layout kann entstehen aus einer begrenzten Anzahl von Kupferpuzzleteilen, die frei kombiniert angeordnet werden.

Die Freiheitsgrade bezüglich der Materialwahl und des Materialaufwands sind groß. Handelt es sich um eine Kunststoffleuchte kann auf zusätzliche Isolationen die über eine Funktionsisolation hinausgehen verzichtet werden. Für thermisch unkritische Anwendungen können kupferkaschierte Labels als Lötpads verwendet werden und somit die Kosten gesenkt werden. Handelt es sich um eine thermisch kritische Anwendung oder wird eine hohe Schaltzyklenfestigkeit gefordert, können die beschriebenen Kupferpads mit einer Stärke von 0,070 mm bis 0,5 mm verwendet werden. Die Länge der Leiterplatte ist durch die Technologie nicht beschränkt. Die Pads die in unterschiedlichen Geometrien vorgehalten werden können, sind flexibel kombinierbar und somit kann die Länge und Breite der Leiterplatten und die Anzahl der LEDs und deren Anordnung (abhängig von verfügbaren Padgeometrien) frei gewählt werden. Das senkt die Lagerkosten, da nur noch unveredeltes Vormaterial gelagert wird.

### BEZUGSZEICHENLISTE

- 100: Leiterfläche
- 110: Bereich mit Lötstopplack
- 120: Bereich mit blanker Kupferoberfläche
- 200: Leiterfläche
- 210: selbstklebende Schicht
- 220: Dielektrikum
- 230: Kupfer
- 240: Lötstopplack
- 300: LED-Modul
- 310: Trägerelement
- 320: Leiterflächen
- 330: Anschluss
- 340: LED
- 400: LED-Modul
- 410: Trägerelement
- 420: Dielektrikum
- 430: Selbstklebende Schicht
- 440: Leiterfläche
- 450: Anschluss
- 460: LED

## Patentansprüche

1. Verfahren zur Herstellung eines LED-Moduls, wobei das Verfahren umfasst:
- Befestigen von Leiterflächen mit einer selbstklebenden Schicht auf einem Trägerelement, wobei das Befestigen der Leiterflächen durch einen SMD-Bestückungsautomaten erfolgt und das Befestigen der Leiterflächen umfasst, die selbstklebende Schicht auf die Leiterflächen aufzubringen und anschließend die Leiterfläche mit der selbstklebenden Schicht an dem Trägerelement zu befestigen, und
- Befestigen einer LED auf den Leiterflächen.

2. Verfahren nach Anspruch 1, wobei die Leiterflächen eine Dicke zwischen 0,07 mm und 0,7 mm aufweisen.

3. Verfahren nach einem der vorherigen Ansprüche, wobei Länge und Breite der Leiterflächen größer als Länge und Breite der LED sind.

4. Verfahren nach einem der vorherigen Ansprüche, wobei die selbstklebende Schicht Polysiloxankleber, Acrylatkleber und/oder ein Polyimid-Klebeband mit einer Stärke von 5 µm bis 100 pm, vorzugsweise einer Stärke von 10 µm bis 50 µm umfasst.

5. Verfahren nach einem der vorherigen Ansprüche, weiterhin umfassend:
- Erfassen von Abmessungen der Leiterflächen und
- basierend auf den Abmessungen, Berechnen einer Platzierung der Leiterflächen, um ein vorgegebenes Layout zu realisieren.

6. Verfahren nach einem der vorherigen Ansprüche, weiterhin umfassend, dass der SMD-Bestückungsautomat die Leiterflächen mit der selbstklebenden Schicht versieht.

7. Verfahren nach einem der vorherigen Ansprüche, wobei die Leiterflächen über eine Schüttgutzuführung, eine Linearzuführung und/oder über eine Rolle als gegurtetes Vormaterial zugeführt werden.

8. Verfahren nach einem der vorherigen Ansprüche, wobei das Trägerelement auf der den Leiterflächen zugewandten Seite elektrisch leitend ist und die Leiterflächen eine Isolationsschicht aufweisen, wobei die Isolationsschicht vorzugsweise an die selbstklebende Schicht angrenzt.

9. Verfahren nach einem der vorherigen Ansprüche, wobei das Trägerelement eine Platte aus Verbund-Kunststoff, Glas und/oder Blech umfasst.

10. Verfahren nach einem der vorherigen Ansprüche, wobei die Leiterflächen Metall, insbesondere Kupfer, umfassen.

## Claims

1. Method for producing an LED module, wherein the method comprises:
- fastening conductor surfaces with a self-adhesive layer on a carrier element, wherein the fastening of the conductor surfaces is carried out by an SMD placement machine and the fastening of the conductor surfaces comprises applying the self-adhesive layer to the conductor surfaces and then fastening the conductor surface with the self-adhesive layer to the carrier element, and
- fastening an LED on the conductor surfaces.

2. Method according to claim 1, wherein the conductor surfaces have a thickness between 0.07 mm and 0.7 mm.

3. Method according to one of the preceding claims, wherein length and width of the conductor surfaces are greater than length and width of the LED.

4. Method according to one of the preceding claims, wherein the self-adhesive layer comprises polysiloxane adhesive, acrylate adhesive and/or a polyimide adhesive tape having a thickness of 5 µm to 100 µm, preferably a thickness of 10 µm to 50 µm.

5. Method according to one of the preceding claims, further comprising:
- detecting dimensions of the conductor surfaces; and
- based on the dimensions, calculating a placement of the conductor surfaces in order to implement a predefined layout.

6. Method according to one of the preceding claims, further comprising the SMD placement machine providing the conductor surfaces with the self-adhesive layer.

7. Method according to one of the preceding claims, wherein the conductor surfaces are supplied via a bulk material supply, a linear supply and/or via a roller as a belted pre-material.

8. Method according to one of the preceding claims, wherein the carrier element is electrically conductive on the side facing the conductor surfaces and the conductor surfaces have an insulation layer, wherein the insulation layer preferably adjoins the self-adhesive layer.

9. Method according to one of the preceding claims, wherein the carrier element comprises a plate made of composite plastic, glass and/or sheet metal.

10. Method according to one of the preceding claims, wherein the conductor surfaces comprise metal, in particular copper.

## Revendications

1. Procédé de fabrication d'un module LED, dans lequel ce procédé comprend :
- la fixation de surfaces conductrices avec une couche auto-adhésive sur un élément de support, dans lequel la fixation des surfaces conductrices a lieu à l'aide d'un automate de montage de SMD et la fixation des surfaces conductrices comprend l'application de la couche auto-adhésive sur les surfaces conductrices puis la fixation des surfaces conductrices avec la couche auto-adhésive à l'élément de support et
- la fixation d'une LED sur les surfaces conductrices.

2. Procédé selon la revendication 1, dans lequel les surfaces conductrices présentent une épaisseur entre 0,07 mm et 0,7 mm.

3. Procédé selon l'une des revendications précédentes, dans lequel la longueur et la largeur des surfaces conductrices sont supérieures à la longueur et la largeur des LED.

4. Procédé selon l'une des revendications précédentes, dans lequel la couche auto-adhésive comprend une colle au polysiloxane, une colle acrylate et/ou une bande adhésive en polyimide avec une épaisseur de 5 µm à 100 µm, de préférence une épaisseur de 10 µm à 50 µm.

5. Procédé selon l'une des revendications précédentes, comprenant en outre :
- la mesure des dimensions des surfaces conductrices et
- sur la base des dimensions, calcul d'un placement des surfaces conductrices, afin de réaliser une mise en place prédéterminée.

6. Procédé selon l'une des revendications précédentes, comprenant en outre le fait que l'automate de montage de SMD équipe les surfaces conductrices de la couche auto-adhésive.

7. Procédé selon l'une des revendications précédentes, dans lequel les surfaces conductrices sont introduites par l'intermédiaire d'une alimentation de produits en vrac, une alimentation linéaire et/ou par l'intermédiaire d'un rouleau, en tant que matériau précurseur attaché.

8. Procédé selon l'une des revendications précédentes, dans lequel l'élément de support est électriquement conducteur sur la face orientée vers les surfaces conductrices et les surfaces conductrices présentent une couche d'isolation, dans lequel la couche d'isolation est de préférence adjacente à la couche auto-adhésive.

9. Procédé selon l'une des revendications précédentes, dans lequel l'élément de support comprend une plaque en matière plastique composite, en verre et/ou en tôle.

10. Procédé selon l'une des revendications précédentes, dans lequel les surfaces conductrices comprennent du métal, plus particulièrement du cuivre.
